# EUROPEAN PATENT APPLICATION

(11) **EP 2 629 326 A2**
(43) Date of publication of application: **21.08.2013**
(21) Application number: 13000486.4
(22) Date of filing: 31.01.2013
(51) Int. Cl.: H01L 21/683

(54) **Substrate transport method and substrate transport apparatus**

(30) Priority: 14.02.2012 JP 2012029416
(71) Applicant: NITTO DENKO CORPORATION, Osaka 567 (JP)
(72) Inventor: Yamamoto, Masayuki, Kameyama-shi, Mie-ken, 519-0193 (JP); Murayama, Takuto, Kameyama-shi, Mie-ken, 519-0193 (JP)
(74) Representative: Hauck Patent- und Rechtsanwälte

(57) **Abstract**

A wafer is formed by molding two or more chips arranged planarly with a resin. The wafer is joined to a support plate via a double-faced adhesive tape having an adhesive layer on one side with a heating separation property, whereby a workpiece is formed. The workpiece is subjected to a given process, and then is heated on a first table for removing the support plate with a support-plate removing device. The wafer removed from the double-faced adhesive tape includes the resin in a softened state. The wafer is then transported while outer periphery on a surface of the wafer on a resin side is suction-held with a suction plate. During transporting the wafer, pressure within the suction head is adjusted in accordance with displacement in level of the wafer.

## Description

### BACKGROUND OF THE INVENTION

### 1. Field of the Invention

This invention relates to a method and apparatus for transporting a substrate, such as a semiconductor wafer and an LED (light Emitting Diode). More particularly, this invention is directed to a technique of dividing a substrate by a dicing process into chips, molding non-defective chips selected from the chips with a resin into a substrate having a circular or quadranglar shape, heating the molded substrate in a given process, and thereafter transferring the substrate.

### 2. Description of the Related Art

In recent years, a semiconductor wafer (hereinafter, appropriately referred to as a "wafer") tends to be ground to have a thickness of several tens micrometers with a need for a high-density package. Accordingly, a circuit and a bump formed on a surface of the wafer may be damaged from a back grinding process until a dicing process, resulting in reduced manufacturing efficiency.

The dicing process is performed to the wafer having a circuit already formed thereon prior to a back grinding process, whereby only non-defective bear chips having a circuit already formed thereon are selected. Only the non-defective chips are molded with a resin to be molded again into a substrate shape. Detailed description thereof is as under.

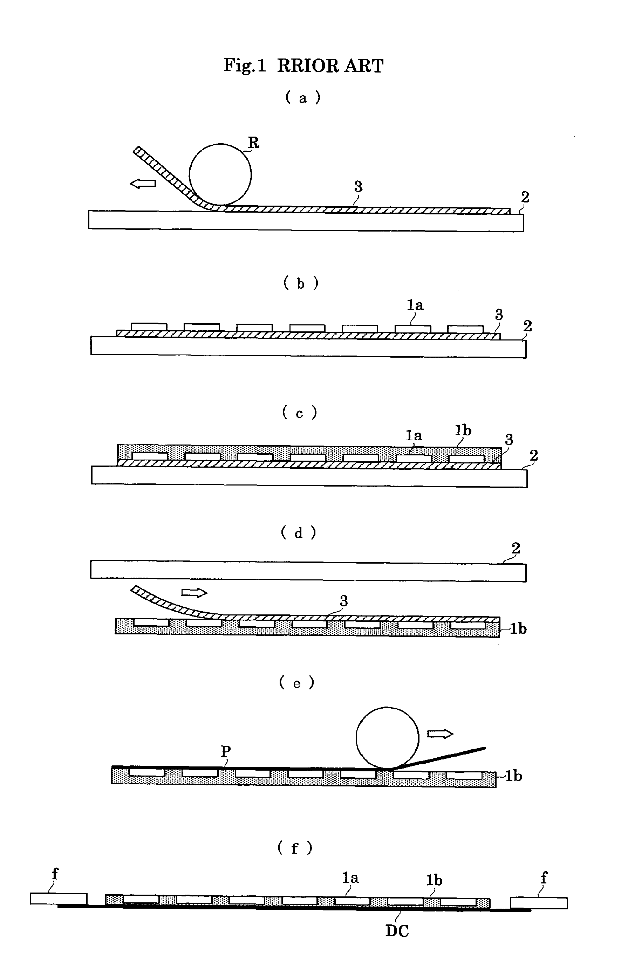

As illustrated in Figure 1(a), an adhesive sheet 3 is pressed with a roller R to be joined to a substrate 2 (e.g., made from aluminum or stainless steel) for support plate. Then, as illustrated in Figure 1(b), the non-defective bear chips 1a are fixedly arranged in a two-dimensional array on the adhesive sheet 3 on the substrate 2 with electrode surfaces of the bear chips 1a being directed downward. Then, as illustrated in Figure 1(c), the bear chips 1a are molded with a resin 1b to be molded again into a wafer shape. As illustrated in Figure 1(d), an adhesive force in the adhesive sheet 3 is decreased to separate the molded wafer 1 from the substrate 2. At this time, the adhesive sheet 3 remains on a substrate 2 side. Subsequently, as illustrated in Figure 1(e), a protective sheet P is joined on the resin 1b on an electrode-surface side where electrodes are exposed from the resin 1b, and is subjected to back grinding is performed in a direction opposite to the electrode surface. Subsequently, as illustrated in Figure 1(f), the protective tape P is separated after the back grinding to obtain a thinned molded wafer 1. The thinned molded wafer 1 is adhesively held on a ring frame f via a support adhesive tape DC, and is transported to a dicing process where the bear chips are diced. See Japanese Patent Publication No. 2001-308116.

In addition, the wafer obtained as above by molding again the non-defective bear chips is transported in a non-contact manner under temperature control. Such has been developed and implemented. See Japanese Patent Publication No. 2011-1511449.

Moreover, for reinforcing decreased rigidity of the wafer due to thinner wafers in recent years, a support plate having the same shape as the wafer is joined to the wafer via a double-faced adhesive tape. The support plate is separated during a mount process. In the method of separating the support plate, a double-faced adhesive tape is used. The double-faced adhesive tape has a heat separation property that reduces or loses adhesion due to foaming and expansion from heating, or includes a pressure-sensitive adhesive layer of ultraviolet curable type. The method of separating the double-faced adhesive tape is conducted by heating the wafer with the support plate prior to the mounting process. See Japanese Patent Publication No. 2005-1116679A.

Moreover, the molded wafer W tends to be further upsized with requirements for high density packing in recent years. Consequently, when the wafer is transported while floating on a transport path in a non-contact manner, since the substrate had its own weight larger than hardness of the resin in an uncured condition, the substrate becomes warped. Such problem may arise.

Moreover, the resin already cured is softened again when heated in a subsequent process. Consequently, similarly to the uncured resin, the molded wafer with the softened resin may become warped when transported in a non-contact manner.

Regardless of whether the resin is softened or not cured, the molded wafer becomes warped, and a resin on the outer periphery of the wafer slightly runs toward a rear face of the wafer due to its own weight. The running resin causes a non-uniform thickness of the wafer. Consequently, the wafer cannot be diced accurately along a desired scrub line in the subsequent dicing process. Such problem may arise.

Moreover, when air is sprayed on the cured resin, a surface of the resin may become waved to generate unevenness on the surface.

Moreover, the wafer is also molded in a square shape other than a conventional circular shape. When the molded wafer is transported in a conventional non-contact manner, the wafer can readily rotate about a vertical axis thereof and thus has difficulty in being transported while a given course is maintained. Consequently, a periphery of the molded wafer contacts to side walls for drop prevention that are provided on both ends of a transport course, resulting in damages on the wafer. Such problem may arise.

Moreover, the resin may be cooled to have a lower temperature than it needs when the molded wafer is transported by a long distance in a non-contact manner. That is, the resin may be cured with warp occurring therein. Such a problem may arise.

### SUMMARY OF THE INVENTION

Additional features of the invention will be set forth in the description which follows, and in part will be apparent from the description, or may be learned by practice of the invention.

This invention has been made regarding the state of the art noted above, and its primary object is to provide a method and apparatus for transporting a wafer that allows efficient cooling with no damage thereon.

One example of this invention discloses a method of transporting a substrate. The method includes a transporting step of suction-holding a substrate in a heated condition with a box-shaped suction head in an unloading position and transporting the substrate into a loading position,
the substrate being formed by molding two or more chips arranged planarly with a resin,
during the transporting step, an outer periphery of the substrate being suction-held with the suction head, the outer periphery extending out of an exposed surface of the substrate on a surface side where the chips are exposed from the resin, and
the substrate being transported to the loading position while being kept planar by decreasing or increasing pressure within the suction head with switching between supplying heated air into the suction head sealed with the substrate and sucking the heated air from the suction head.

According to the method mentioned above, since the resin is readily bent in a softened state at a glass transition temperature or more or even less, running of the resin likely occurs at the outer periphery of the substrate due to its own weight. On the other hand, since the outer periphery of the substrate is suction-held with the suction head, the running can be avoided. In addition, since the substrate is transported while being suction-held with the suction head. Consequently, the substrate is ensured to be transported into a target position along a given transport path while an attitude of the substrate is maintained. As a result, the substrate can be prevented from contacting to the other structures to be damaged during a transport process.

Moreover, an inner-side portion of the substrate in a non-contact state with the suction head tends to warp downward due to heating. However, pressure within the suction head sealed by the substrate is reduced, whereby the substrate enables to be kept planar. On the other hand, when the resin is cured as it is rapidly cooled, the inner-side portion of the substrate may warp upward due to difference in shrinkage between the resin and the chip. However, applying pressure within the suction head sealed with the substrate enables to avoid rapid curing of the resin. Consequently, the substrate enables to be kept planar. Thus, the substrate with the resin in a heated condition can be transported into the target position while being kept planar.

The method mentioned above is preferably conducted as under. For instance, pressure is applied within the suction head by supplying gas having temperatures between a preset temperature in the unloading position and that in the loading position. Then the substrate is delivered to a transport position when the resin is cooled down into a given temperature.

The method mentioned above enables the resin having the highest temperature at start of transportation to be controlled so as to have temperatures between a temperature in the unloading position and that in the loading position until the wafer is transported into the loading position. In other words, the resin is cooled not rapidly but gradually. As a result, warp of the wafer can be eliminated, the warp occurring due to difference in shrinkage between the resin and the chip. Moreover, damages in the wafer due to the warp can also be eliminated.

It is preferable that a detector detects displacement in level of the substrate during the transport step. At least either a supplied amount of gas into the suction head or a suction amount of gas from the suction head is adjusted in accordance with detection results from the detector. In addition, it is preferable that a temperature within the suction head is detected while the substrate is transported and a temperature of gas to be supplied into the suction head is adjusted in accordance with detection results from the detector.

The method mentioned above allows adjusting at least either pressure or a temperature within the suction head in accordance with displacement in level of the substrate. Consequently, warp of the substrate can be corrected appropriately.

Another example of this invention discloses an apparatus for transporting a substrate. The apparatus includes a transport mechanism with a box-shaped suction head for suction-holding an outer periphery of the substrate formed by molding two or more chips arranged planarly with a resin in a heated condition, the outer periphery extending out of an exposed surface where the chips are exposed from the resin; a gas compressor for supplying gas into the suction head sealed with the substrate or sucking the gas from the suction head; a heater for heating the gas supplied from the gas compressor; a detector for detecting displacement in level of the substrate suction-held by the suction head; and a controller for adjusting at least either a supplied amount or a suction amount of the gas by detecting the displacement in level of the substrate during transporting while suction-holding the substrate with the suction head, and switching positive pressure and negative pressure within the suction head by the gas compressor in accordance with detection results from the detector.

The configuration of the apparatus mentioned above enables the suction head to suction-hold the outer periphery of the substrate. In addition, the configuration also enables to control the temperatures and pressure of the gas supplied into the suction head. Specifically, when the detector detects displacement in level of the substrate due to warp in the inner-side portion of the substrate, the gas heated is supplied into the suction head such that the suction head is in a pressurized state or the gas is sucked from the suction head such that the suction head is in a pressure-reduction state. Consequently, the substrate returns to be planar utilizing characteristics of the resin that readily deforms due to heating. Accordingly, the foregoing method may suitably be conducted with the apparatus.

The apparatus mentioned above further includes a temperature sensor for detecting a temperature of the suction head sealed with the substrate. The controller compares an actual measurement value of the temperature determined by the temperature sensor with a reference value of the temperature determined in advance, operates the heater in accordance with deviation determined, and supplies the gas having a controlled temperature into the suction head. Such configuration is preferable.

This configuration makes it easy to keep the substrate planar while the temperature of the resin is adjusted.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.
Figure 1 is an explanatory view illustrating a manufacturing process of a molded wafer according to the prior art.
Figure 2 is a plan view illustrating a whole configuration of an apparatus according to one example.
Figure 3 is a side view of a workpiece having a support plate joined to the molded wafer.
Figure 4 is a sectional view of the molded wafer.
Figure 5 is a schematic overall perspective view of a third substrate transport apparatus.
Figure 6 is a plan view of the third substrate transport apparatus.
Figure 7 is a longitudinal sectional view of the third substrate transport apparatus.
Figure 8 is a front view of the third substrate transport apparatus.
Figure 9 is a block diagram of the third substrate transport apparatus.
Figure 10 is a side view of a support-plate removing mechanism.
Figure 11 is a plan view of the surrounding of a first table.
Figure 12 is a front view of the surrounding of the first table.
Figure 13 is a perspective view of a separation roller.
Figures 14 through 16 are explanatory views each showing operation of removing a support plate.
Figure 17 is an explanatory views showing operation of separating a double-faced adhesive tape.
Figure 18 is a flow chart illustrating pressure adjustment within a suction head.
Figures 19 and 20 are explanatory views each showing operation of a wafer transport apparatus.
Figures 21 and 22 are schematic views each illustrating adjustment in shape of the wafer.

### DESCRIPTION OF THE PREFERRED EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers and regions may be exaggerated for clarity. Like reference numerals in the drawings denote like elements.

Hereinafter, description will be given of an embodiment of the present invention with reference to the drawings.

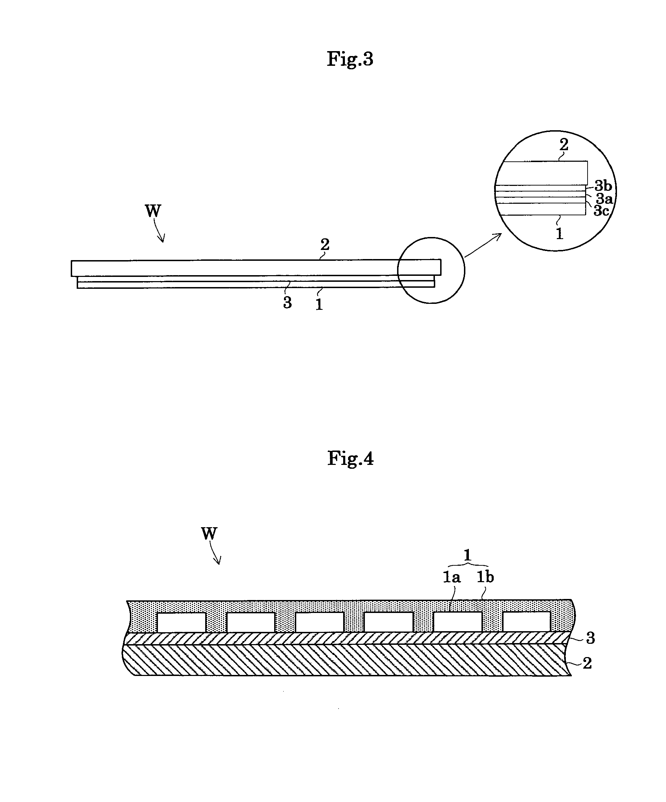

A substrate transport apparatus in one example of this invention is provided in a support-plate separating device. The support-substrate separating device separates a wafer 1 prior to back grinding from a support plate 2, the wafer 1 being joined coaxially to the support plate 2 via a double-faced adhesive tape 3, as illustrated in Figure 3. The support plate 2 is formed of a stainless steel, a glass substrate, or a silicon substrate. Here, the support plate 2 has a size equal to or larger than the wafer 1.

Here, the wafer 1 is formed as follows. That is, bear chips 1a in Figure 4 to which a dicing process is performed are inspected after circuit formation on a wafer surface for sorting out only non-defective bear chips 1a. The non-defective bear chips 1a are fixedly arranged in a two-dimensional array on the double-faced adhesive tape 3 joined to the support plate 2 with electrode surfaces of the chips being directed downward. Moreover, the bear chips 1a are covered with a resin 1b to be molded into a wafer shape.

Now referring again to Figure 3, the double-faced adhesive tape 3 includes a tape base material 3a having adhesive layers 3b and 3c on opposite surfaces thereof respectively.

The adhesive layer 3b with a heat separation property loses its adhesion due to foaming and expansion through heating. The adhesive layer 3c is ultraviolet curable type that reduces its adhesion due to curing by irradiation with ultraviolet rays, or a non-ultraviolet curable type and pressure-sensitive. That is, the support plate 2 is joined to the adhesive layer 3b, whereas the wafer 1 is joined to the adhesive layer 3c.

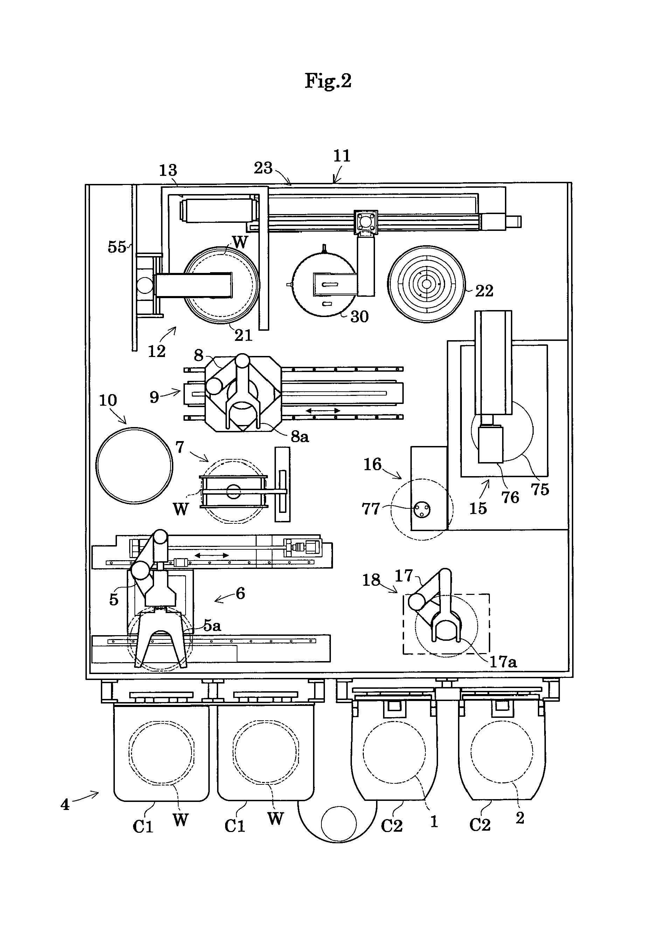

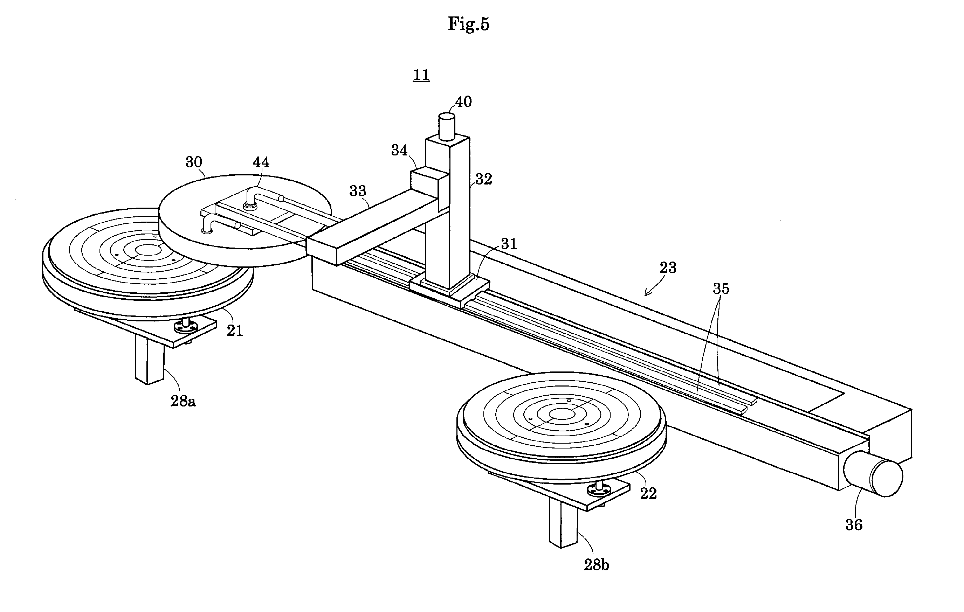

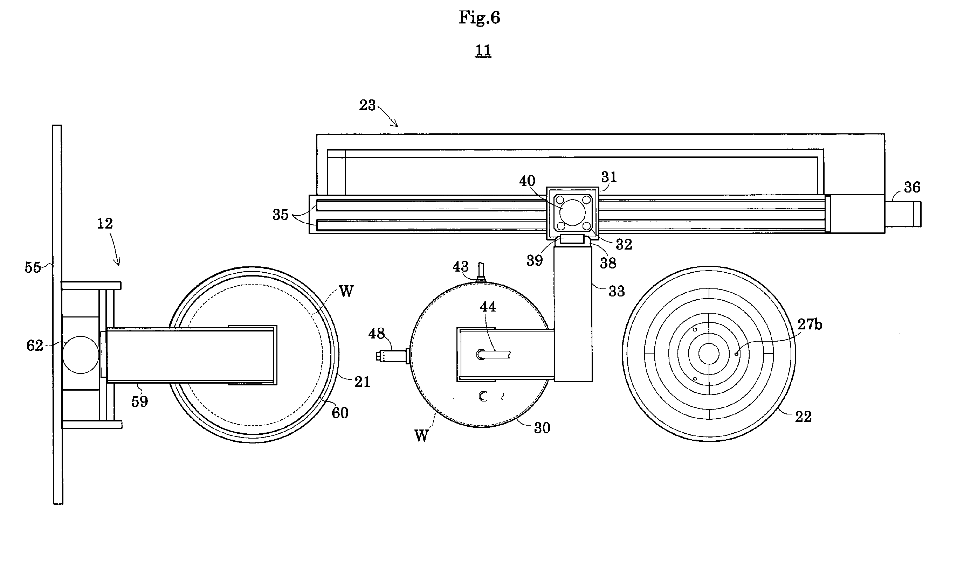

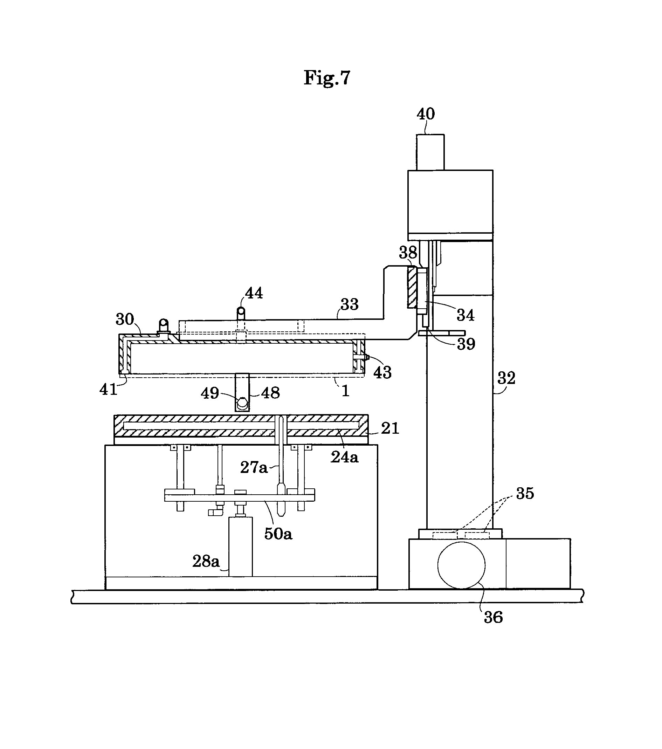

Figure 2 is a plan view of a support plate separating device according to one example of this invention. Figure 5 is a schematic overall perspective view of a third substrate transport apparatus. Figure 6 is a plan view of the third substrate transport apparatus. Figure 7 is a longitudinal sectional view partially illustrating the third substrate transport apparatus.

The support-plate removing device includes a wafer supply/collecting section 4, a first substrate transporting mechanism 6, a cooling mechanism 7, a second substrate transporting mechanism 9, a preheating table 10, a third substrate transporting device 11, a support-plate removing mechanism 12, a tape removing mechanism 13, a tape collecting section 14, a marking section 15, a wafer delivering section 16, and a fourth substrate transporting mechanism 18.

The wafer supply/collecting section 4 has cassettes C1 and cassettes C2 mounted thereon. The cassette C1 houses workpieces W. The cassette C2 houses the wafers 1 and the support plates 2.

The first wafer transporting mechanism 6 has a first robot arm 5. The second wafer transporting mechanism 9 has a second robot arm 8.

The support-plate removing mechanism 12 removes the support plate 2 from the workpiece W.

The tape separating mechanism 12 separates the double-faced adhesive tape 3 from the wafer 1 from which the support plate 2 has been removed.

The tape collecting section 14 collects the removed double-faced adhesive tapes 3.

The marking section 14 marks the wafer 1.

The fourth wafer transporting mechanism 18 has a fourth robot arm 17.

Next, each mechanism will be described in detail.

The wafer supply/collecting section 4 has two cassettes C1 on a supply side and two cassettes C2 on a collection side that are arranged in parallel. The cassettes C1 each house the workpieces W inserted thereinto horizontally in a stack manner with the wafer 1 and the support plate 2 joined together, where the support plate 2 is directed downward. One cassette C2 houses the wafers 1 inserted thereinto horizontally in a stack manner. The support plate 2 is each removed from the wafer 1 and the wafer 1 each have a circuit surface of the bear chips 1a directed upward. The other cassette C2 houses the removed support plates 2 inserted thereinto horizontally in a stack manner.

The first robot arm 5 of the first substrate transporting mechanism 6 is reversible and movable horizontally. Further, the first robot arm 5 is turnable and movable vertically as a whole. The first robot arm 5 has a tip end provided with a U-shaped workpiece holder 5a of a vacuum-suction type. Moreover, the workpiece holder 5a includes an alignment mechanism. For instance, the workpiece holder 5a has holders at two portions on a tip-end side thereof. The holders are directed upward. The workpiece holder 5a also has two movable pins at corners on a proximal end thereof. When the movable pins are moved, they sandwiches the workpiece W together with the holder for aligning and holding the workpiece W.

The cooling mechanism 7 is formed by a suction pad and a cooling unit. The suction pad sucks the support plate 2 in a heated condition at a center region thereof for rotating the support plate 2. The cooling mechanism 7 includes a cooling unit disposed above the suction pad for spraying air on the rotating support plate 2.

The second robot arm 8 of the second substrate transporting mechanism 9 is movable horizontally. Further, the robot arm 8 is turnable and movable vertically as a whole. The second robot arm 8 has a tip end provided with a U-shaped workpiece holder 8a of vacuum-suction type.

The preheating table 10 is a chuck table having a larger size than the workpiece W and having suction grooves with a minute width (e.g., 1 mm or less) being formed on a front face thereof. The preheating table 10 is made from a heat-insulating material. The preheating table 10 includes inside thereof a heater and a temperature sensor. The temperature sensor detects temperatures on a surface of the workpiece W. Detection signals of the temperature sensor are transmitted to a controller 80. Moreover, the preheating table 10 further includes two or more support pins for moving the workpiece upward and downward such that a surface of the workpiece protrudes and retracts. Moreover, the tip of the support pin is formed of an insulator, or is covered with an insulator.

As shown in Figures 4 to 7, the third substrate transporting device 11 includes a first table 21, a second table 22, and a wafer-transporting mechanism 23. Here, the third substrate transporting device 11 corresponds to the substrate transport apparatus in this invention.

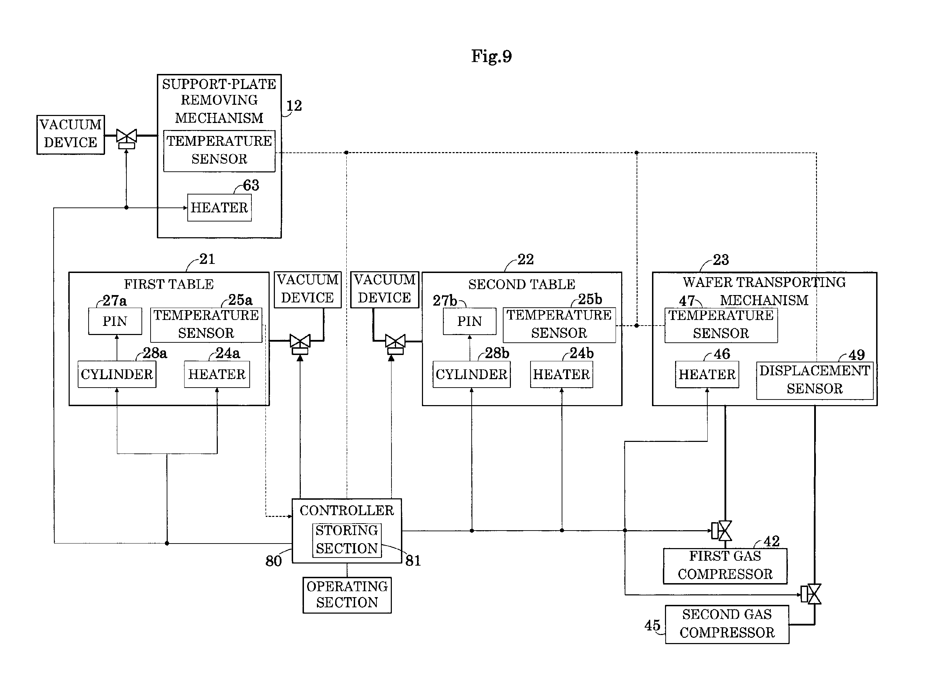

The first table 21 is a chuck table having a larger size than the workpiece W and having suction grooves with a minute width (e.g., 1 mm or less) being formed on a front face thereof. The first table 21 is formed of a heat-insulating material, and includes inside thereof a heater 24a and a temperature sensor 25a (see Figure 9). The temperature sensor 25a detects temperatures on a surface of the workpiece W, and transmits detection signals to the controller 80.

The first table 21 is in communication with an external vacuum device via a channel. The first table 21 also has two or more support pins 27a.

The two or more support pins 27a are spaced away at regular intervals on a given circumference of the first table 21. That is, these pins 27a are provided on a movable table 50a. Specifically, the pin 27a is movable upward and downward from a holding surface of the first table 21 via a cylinder 28a coupled to the movable table 50a. Moreover, the tip of the support pin 27a is formed of an insulator, or is covered with an insulator.

A second table 22 has generally the same configuration as the first table 21. Consequently, a letter of the alphabet "b" is merely given to the number of the same element.

A wafer-transporting mechanism 23 includes a suction head 30 that enables to move horizontally and vertically. That is, the wafer-transporting mechanism 23 is formed by a horizontally movable table 31, a support frame 32, an arm 33, a lifting table 34, and the suction pad 30.

The horizontally movable table 31 is slidingly supported so as to move horizontally along a pair of guide rails 35 arranged in parallel. The horizontally movable table 31 is driven in a screw-feed manner by a screw shaft that rotates forward/backward by a motor 36.

The support frame 32 is erected on the horizontally movable table 31. As illustrated in Figures 6 and 7, a box-shaped base 33 is connected to a middle region of the support frame 32.

The lifting table 34 is slidingly supported so as to move vertically via an upright rail 39 on the base 38 by a screw shaft that rotates in connection with a motor 40. The suction head 30 is attached to a tip of an arm 33 that extends from the lifting table 34.

The suction head 30 has a box shape with a diameter larger than that of the wafer 1. That is, the suction head 30 suction-holds the outer periphery of the wafer 1. The outer periphery extends out of the exposed surface on the surface side of the wafer 1 where the chips are exposed to an outer edge of the wafer 1. Consequently, the suction head 30 has an annular suction groove 41 formed on a lower edge of the side wall. As illustrated in Figure 9, the suction groove 41 is communicated with a first gas compressor 42 via a channel formed within the side wall and via an external channel connected to one end of the channel. Moreover, an individual channel is communicated with inside of the suction head 30. This channel is provided with a relief valve 43.

The suction head 30 is in communication with a second gas compressor 45 via an external channel 44 connected to a channel formed in the middle of the top portion. The second gas compressor 45 enables to switch between driving under positive pressure and driving under negative pressure by the controller 80. Here, the external channel 44 is connected to an electromagnetic valve. The magnetic valve enables to adjust a flow rate of gas passing through the channel.

Moreover, the suction head 30 has a heater 46 embedded therein. The heater 46 heats gas supplied to an enclosed space between the suction head 30 and the wafer 1. The suction head 30 includes a temperature sensor 47. The temperature sensor 47 determines temperatures of gas supplied within the suction head 30 with the heater 46.

In addition, a flange 48 is attached downwardly from the side wall of the suction head 30. The flange 48 includes a displacement sensor 49 at a tip thereof. In this example, a laser sensor is used for the displacement sensor 49. The displacement sensor 49 detects displacement of the wafer 1 from the rear face side of the wafer 1 suction-held with the suction head 30. That is, the displacement sensor 49 detects running and warp of the wafer 1. Here, the displacement sensor 49 corresponds to the detector in the example of this invention.

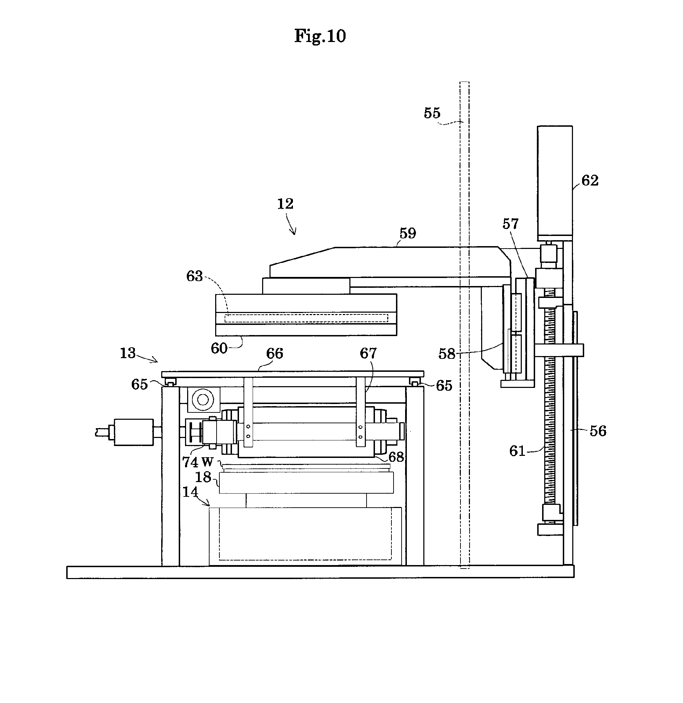

As illustrated in Figure 10, the support-plate removing mechanism 12 includes an upright wall 55, a movable table 57, a movable frame 58, and a suction plate 60.

The movable table 57 can move upward and downward along a rail 56 provided behind the upright wall 55 in a vertical direction. The movable table 57 moves upward and downward in a screw-feed manner by backward and forward rotation of a screw shaft 61 by a motor 62.

The movable frame 58 is attached to the movable table 57 so as to be adjustable in level.

The suction plate 60 is attached to a tip of an arm 59 that extends forward from the movable frame 58. Moreover, a bottom of the suction plate 60 is formed as a vacuum-suction face. Moreover, the suction plate embeds a heater 63.

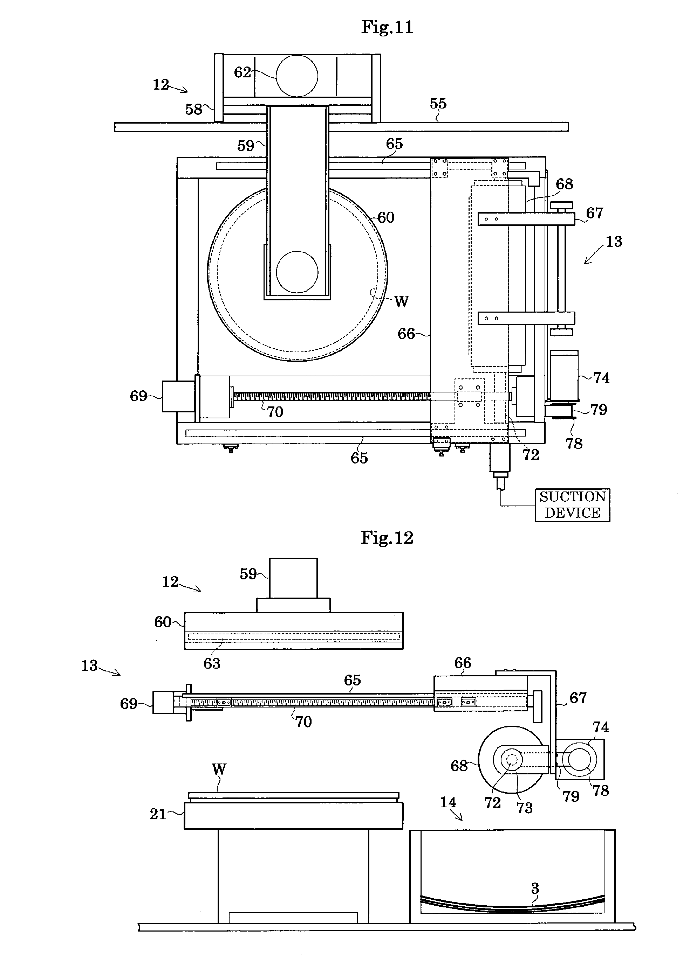

As illustrated in Figures 11 to 13, the tape separating mechanism 13 includes a movable table 66 and a separation roller 68.

The movable table 66 can slide forward/backward along a rail 65. The movable table 66 independently moves in a screw-feed manner through a screw shaft 70 that rotates backward/forward with a motor 69.

The separation roller 68 is attached to a support frame 67 that extends downward from the movable table 66.

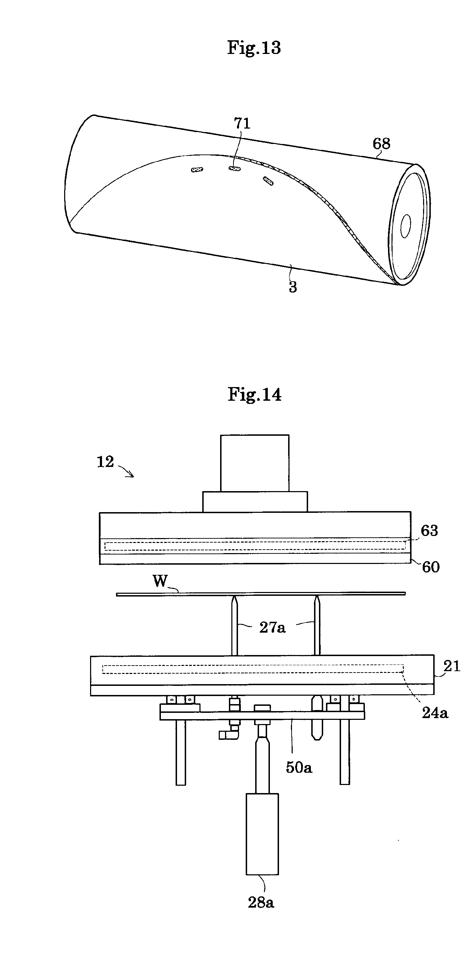

The separation roller 68 can rotate on its axis. Specifically, an endless belt 79 is suspended between a pulley 73 attached to a hollow rotation shaft 72 and a driving pulley 78 attached to a driving shaft of a motor 74. Moreover, as illustrated in Figure 13, the separation roller 68 is provided with suction holes 71 on a surface thereof. The separation roller 68 is communicated with an external suction device. Here, the separation roller 68 is covered with an elastic body.

The suction holes 71 are formed at positions corresponding to a separation-start end and a separation-termination end of the double-faced adhesive tape 3. Two or more holes are formed as the suction holes 71 on the separation-start end along an arc of the outer periphery of the tape 3. One long hole is formed as the suction hole 71 on the separation-termination end. The shape and number of the suction hole 71 may vary depending on size and shape of the double-faced adhesive tape 3.

As illustrated in Figure 12, the tape collecting section 14 is provided below the separation roller 68 as a collection box.

Referring again to Figure 2, the marking section 15 includes a chuck table 75 and a laser device 76.

The chuck table 75 suction-holds the wafer 1. The laser device 76 performs marking, such as a two-dimension code and a three-dimensional solid code, to the wafer 1 suction-held with the chuck table 75.

The wafer delivery section 16 includes a suction pad 77 for suction-holding a rear face of the wafer 1 and the support plate 2. The suction pad 77 slidingly moves from a marking section 15 side toward a delivery position to a fourth robot arm 17, and moves upward and downward.

The fourth robot arm 17 of the fourth substrate transporting mechanism 18 is movable horizontally. Further, the fourth robot arm 17 is turnable and movable vertically as a whole. The fourth robot arm 17 has a tip provided with a U-shaped workpiece holder 17a of vacuum suction type.

Next, description will be given of a series of operation of the support-plate removing device with the wafer transporting device with reference to Figures 9 to 22.

First, an operation section illustrated in Figure 9 operates for various settings. For instance, setting is made as for various conditions such as a heating temperature of the heater in the preheating table 10, a heating temperature of the heater 63 in the support-plate removing device 12, and a heating temperature and time of each heater embedded in the first table 21, the second table 22, and the suction head 30.

The heating temperature of the preheating table 10 is determined as follows, for example. When the wafer 1 and the support plate 2 are joined to the double-faced adhesive tape 3, at least either the double-faced adhesive tape 3 or the resin 1b expands due to pressures from a joining member. In other words, upon completion joining, restoring force is accumulated in the resin 1b and/or the double-faced adhesive tape 3. Consequently, the restoring force may cause slight warp in the workpiece W formed by joining the wafer 1 and the support plate 2 together. Then, warp of the workpiece W is corrected. Specifically, a temperature at which at least either the resin 1b or the double-faced adhesive tape 3 is softened moderately is set such that the workpiece W may become flat. Since the temperature and time vary in accordance with properties of the resin 1b and the double-faced adhesive tape 3 to be used, they are determined through experiments, simulations in advance.

The heating temperature in the support plate separating mechanism 12 is set in accordance with the double-faced adhesive tape 3 having the adhesion layer 3b with a heat separation property. That is, a temperature is set at which the double-faced adhesive tape 3 foams and expands due to heating and reduces or eliminates its adhesion.

In this example, for example, heating temperatures of the first table 21, the second table 22, and the suction head 30 are set to become lower in order of the first table 21, suction head 30, and the second table 22. Setting of the heating temperature is not restricted to this order, but may be modified properly in accordance with properties of the resin to be used and shapes or weights of the wafer 1.

First, the heating temperature of the first table 21 is set at a temperature at which the adhesive layer 3b of the double-faced adhesive tape 3 foams and expands together with the support-plate removing mechanism 12.

The heating temperature of the second table 22 is set such that the temperature of the wafer 1 is approximately room temperatures.

The heating temperature and time for the suction head 30 are set more strictly than those of the second table 22. Specifically, when the suction head 30 contacts the resin 1b softened on the first table 21 to cool the resin directly, the heating temperature and time are set as temperatures and times at which conditions are satisfied. In the condition, for example, the softened resin 1b does not run or deform due to its own weight at an edge side of the wafer 1. Since the condition varies in accordance with the resin 1b to be used, it is determined through experiments, simulations in advance. For instance, examples of the condition include a temperature close to the glass transition temperature of the resin 1b or a range containing the glass transition temperature.

The various setting conditions are stored in a storing section 81 provided in the controller 80.

Upon completion of setting for the various conditions, the apparatus operates. Firstly, the first robot arm 5 in the first substrate transporting mechanism 6 moves toward the cassette C1. The workpiece holder 5a at the tip end of the first robot arm 5 is inserted between the workpiece W housed in the cassette C1. The workpiece holder 5a suction-holds the rear face of the wafer W and transports the wafer W. That is, the support plate 2 is held and unloaded. Alignment is also performed in the transporting process. Then, the workpiece holder 5a reverses the workpiece W upside down to direct the resin 1b of the wafer 1 downward. Then the workpiece holder 5a moves the workpiece W to place it on the preheating table 10.

At this time, the pins project over the holding surface of the first table, whereby the preheating table 10 receives the workpiece W, and moves downward. The workpiece W is suction-held on the preheating table 10, and thereafter is heated to a given temperature. The temperature of the workpiece W is detected by a temperature sensor during preheating treatment. When the workpiece W reaches the given temperature, the workpiece W is moved upward by the pins. Here, the resin 1b or the double-faced adhesive tape 3 is softened slightly, and restoring force in the resin 1b or the double-faced adhesive tape 3 is released. Consequently, slight warp in the workpiece W is eliminated to be planar.

The workpiece W on the preheating table 10 is suction-held with the second robot arm 8 from a front face side, and the workpiece W is transported onto the first table 21. That is, the second robot arm 8 suction-holds the support plate 2.

As illustrated in Figure 14, the workpiece W transported on the first table 21 is supported at the middle region thereof by the pins 27a projected over the table, and then the pins 27a are moved downward. Consequently, the workpiece W is suction-held on the first table 21 while the resin 1b is directed downward. At this time, the first table 21 is heated into a given temperature in advance with the heater 63.

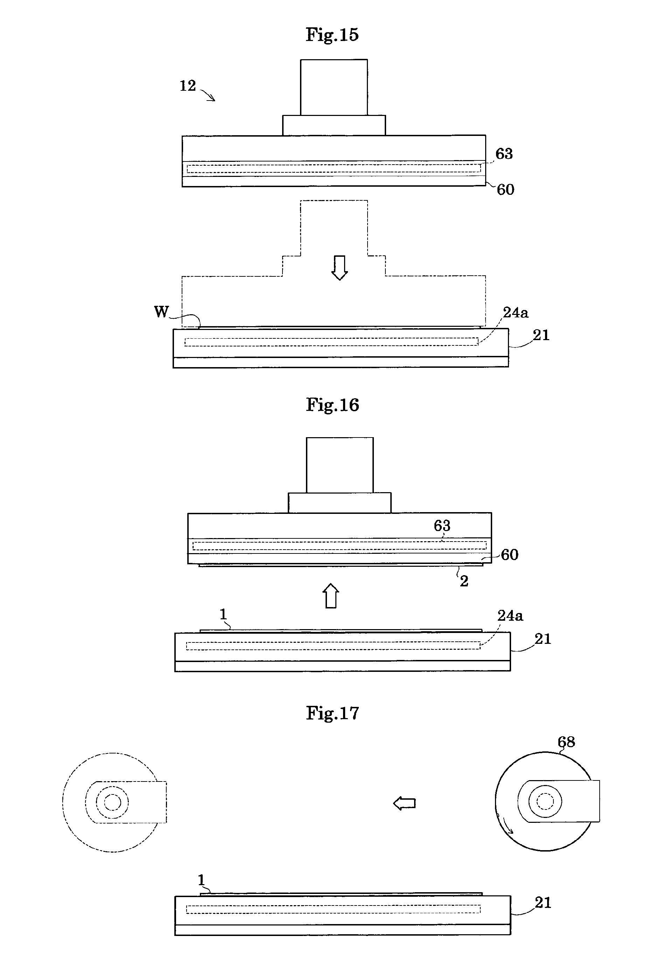

Subsequently, as illustrated in Figure 15, the suction plate 60 of the support-plate removing mechanism 12 moves downward until the plate contacts the upper surface of the workpiece W. Then the workpiece W is heated with the heater 63 embedded in the suction plate 60 in corporation with the heater 24a in the first table 21. Consequently, the adhesive layer 3b with heating separation properties on the double-faced adhesive tape 3 foams and expands due to heating with the suction plate 60 and the first table 21, resulting in loss of adhesion.

When heating for a given time is completed, the suction plate 60 moves upward while the support substrate 2 is suction-held, as illustrated in Figure 16. Here, the adhesive layer 3b having no adhesion is separated from the lower surface of the support plate 2. Accordingly, only the support plate 2 moves upward.

The wafer 1 is held on the first table 21 from which the support plate is removed. Here, on the wafer 1, the double-faced adhesive tape 3 remains that expands to lose its adhesion and has the exposed adhesive layer 3b with the uneven surface. As illustrated in Figure 17, the separation roller 68 is moved from the standby position to the separation-starting position.

Here, the separation roller 68 stops at the separation starting end. Moreover, the separation roller 68 rotates to control the position of the suction holes 71 as to be directed downward for sucking the separation starting end of the double-faced adhesive tape 3.

Upon completion of control in position of the separation roller 68 in the separation starting position, the cylinder operates to move the first table 21 upward to appropriately press the double-faced adhesive tape 3 by the separation roller 68. Simultaneously, the separation roller 68 moves toward the separation termination end while sucking the double-faced adhesive tape 3, thereby winding up and separates the double-faced adhesive tape 3.

When the separation roller 68 moves across the separation termination end to the standby position, the suction device is switched to positive pressure. Accordingly, air blows out from the suction holes 71 for separating the double-faced adhesive tape 3 from the separation roller 68 and collecting the tape into the collection box in the tape collecting section 13.

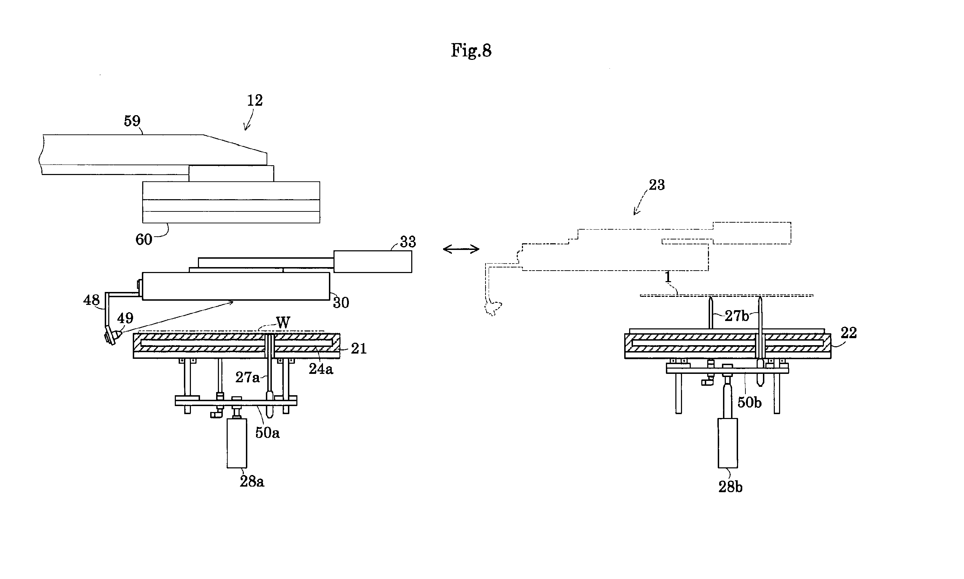

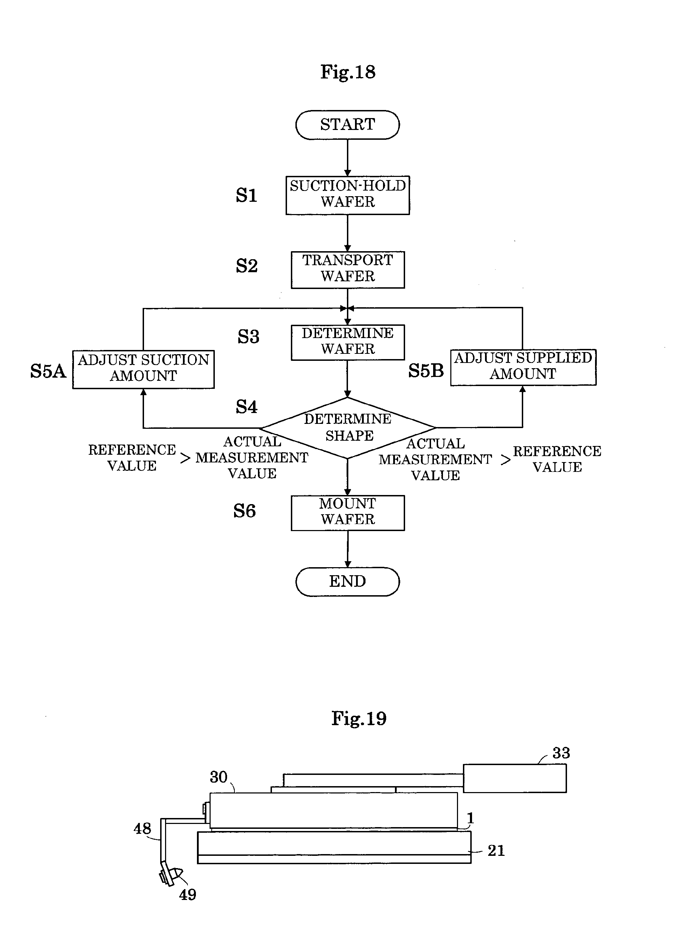

Subsequently, description will be given of a process of transporting a wafer 1 with the flow chart of Figure 18. As illustrated in Figure 8, the suction head 30 of the wafer-transporting mechanism 23 is moved into a position above the first table 21. The suction head 30 in a given position is moved downward into a given level. Then, as illustrated in Figure 19, a lower end of the suction head 30 contacts the outer periphery of the wafer 1 extending out of the exposed surface of the wafer 1 where the chips are exposed to an outer edge of the wafer 1. In this condition, the first table 21 releases its suction-holding of the wafer 1 and the suction head 30 starts suction-holding of the wafer 1 (STEP S1).

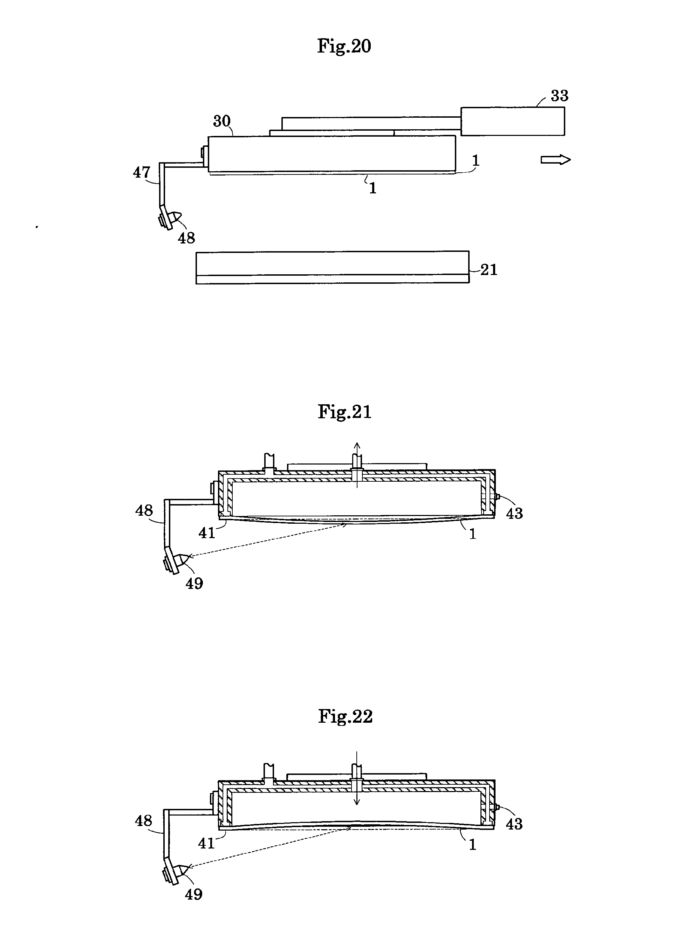

When the suction head 30 suction-holds the wafer 1, the suction head 30 moves upward to transport the wafer to the second table 22, as illustrated in Figure 20 (STEP S2).

During transporting the wafer 1 as above, the displacement sensor 49 starts determining of the middle portion in the rear face of the wafer 1 (STEP S3).

Detection signals from the displacement sensor 49 are transmitted to the controller 80. The controller 80 determines an actual measurement value in level from the detection signals, and compares the actual measurement value with a reference value determined in advance (STEP S4). Specifically, where the actual measurement value is smaller than the reference value, it is determined that the wafer 1 has warp downward, as illustrated in Figure 21. In this case, the process proceeds to STEP S5A. In contrast to this, where the actual measurement value is larger than the reference value, it is determined that the wafer 1 has warp upward, as illustrated in Figure 22. In this case, the process proceeds to STEP S5B.

In STEP S5A, the controller 80 operates the second gas compressor 45 under negative pressure. That is, the second gas compressor 45 sucks only a given amount of gas within the suction head 30. The suction amount of gas is adjusted in accordance with deviation between a volume of the suction head 30 already determined in accordance with the actual measurement value in level of the wafer 1 and a volume that satisfies the reference value. Moreover, during the adjustment above, the displacement sensor 49 determines a level of the rear face of the wafer 1, and the suction amount of gas is adjusted such that the level reaches the reference value.

In STEP S5B, the controller 80 operates the second gas compressor 45 under positive pressure. That is, the second gas compressor 45 supplies a given amount of gas within the suction head 30. Where pressure within the suction head 30 increases more than predetermined, gas is discharged from the relief valve 43, resulting in no damage in the wafer 1. The supplied amount of gas is adjusted in accordance with deviation between a volume of the suction head 30 already determined in accordance with the actual measurement value in level of the wafer 1 and a volume that satisfies the reference value. Moreover, during the adjustment above, the displacement sensor 49 determines a level of the rear face of the wafer 1, and the suction amount of gas is adjusted such that the level reaches the reference value. The gas to be supplied is maintained at a given temperature by the heater 46 embedded in the suction head 30.

When the suction head 30 reaches a position above the second table 22, the suction head 30 moves downward into a given level to contact to the rear face of the wafer 1. At this time, the second table 22 operates suction of the second table 22 heated into a given temperature, and the suction head 30 releases its suction-holding (STEP S6).

Since the suction head 30 is heated into a temperature lower than that of the first table 21 upon delivering the wafer 1 from the suction head 30 to the second table 22, the wafer 1 is cooled into a target temperature. At this time, the wafer 1 is kept planar. Consequently, warp due to difference in expansion coefficient between the resin 1b and the bear chip 1b is eliminated. Moreover, deformation or running of the resin 1b is restricted by contact of the suction plate, and thus the wafer is kept planar.

The controller 80 monitors temperatures of the wafer 1 in accordance with the detection signals from temperature sensor 25b. When the temperature of the wafer 1 reaches room temperatures, the wafer 1 is unloaded from the second table 22. Firstly, suction-holding of the wafer 1 on the second table 22 is released, and the pins 27b are moved upward. Then, the wafer 1 is spaced away from the second table 22. Thereafter, the second robot arm 8 of the second substrate transporting mechanism 9 suction-holds the rear face of the wafer 1, and transports the wafer 1. Subsequently, the pins 27b are moved downward inside of the second table 22.

The wafer 1 is placed on the chuck table 75 in the marking section 15 by the second robot arm 8 for alignment based on a notch. Thereafter, a given outer periphery portion on an exposed surface of the wafer 1 is marked with laser.

Upon completion of the marking, the second robot arm 8 again suction-holds the wafer 1. Then, the second robot arm 8 places the wafer 1 onto a wafer delivery section 16. The wafer 1 is moved to a delivery position of a fourth robot arm 17 while the suction pad 77 suction-holds the rear face of the wafer 1.

Then, the fourth robot arm 17 suction-holds the rear face of the wafer 1, and houses the wafer into the cassette C2 with an exposed surface of the bear chip 1a directed upward.

While the wafer transporting mechanism 23 transports the wafer 1, the support plate 2 is collected into the cassette C1 via another path.

The support plate 2 removed by the support plate removing mechanism 12 and suction-held on the suction plate 60 is suction-held by the second robot arm 8 on the rear face thereof. The second robot arm 8 delivers the wafer 1 onto a suction pad of the cooling mechanism 7. The suction pad suction-holds the rear face of the support plate 2 and rotates the support plate 2. The cooling unit sprays air onto the surface of the support plate 2 in synchronism with rotation of the suction pad. When the support plate 2 reaches room temperatures as the target temperature, air stops being supplied and the suction pad stops rotating.

The first robot arm 5 suction-holds the surface of the support plate 2 to turn the support plate 2 upside down. Thereafter, the first robot arm 5 houses the wafer into a given empty space of the cassette C1.

As noted above, a round of operation is completed. The similar operation is to be repeated hereinafter.

According to the foregoing exemplary apparatus, when the support plate 2 is removed by the first table 21, the first table 21 is heated at high temperatures and the resin 1b of the wafer 1 is in a softened state. On the other hand, since the suction head 30 is heated at a temperature lower than that of the first table 21, the annular lower end of the suction head 30 is brought into contact to the resin 1b. The suction head 30 suction-holds the resin 1b, whereby the wafer 1 is cooled into a temperature at which no running of the resin or deformation of the wafer occurs due to its own weight of the resin 1b at the outer periphery of the wafer 1.

Moreover, since the displacement sensor 49 determines and corrects appropriately displacement of the middle portion of the wafer 1, the wafer 1 is kept planar.

As noted above, the wafer 1 is suction-held with the suction head 30 so as to eliminate warp of the wafer or running of the resin 1b due to the softened resin 1b. Consequently, the wafer 1 is cooled until the hardness of the resin 1b exceeds its own weight of the wafer 1, and thus no deformation occurs in the resin 1b. As a result, the wafer 1 is transported under a planar state. Moreover, no running of the resin occurs on the outer periphery of the wafer 1. Thus the wafer 1 has a uniform thickness and enables to be held horizontally during the subsequent dicing process. Consequently, the wafer 1 enables to be diced accurately along a desired scrub line.

Moreover, the suction head 30 enables to transport the wafer 1 into a given position while heating the wafer 1 at a given temperature or more. Consequently, although the wafer 1 having the heated resin 1b is transported by a long distance as in the conventional apparatus that transports the wafer in a non-contact manner, the wafer is no longer cooled down into a lower temperature than it needs while the wafer warps, and the warped wafer is not fixed.

Moreover, when the wafer 1 has a diameter of 12cm or more, it becomes difficult to conventionally control a flow rate of air to float the wafer 1 and transport the wafer 1 accurately along a given path. Consequently, the wafer 1 contacts the side wall for drop prevention and thus is damaged.

On the other hand, the apparatus according to the example mentioned above enables the wafer 1 to be transported while being covered with the suction head 30 having a diameter larger than the wafer 1. Consequently, the wafer 1 is ensured to be transported on a given transportation path without contacting the edge thereof to other elements. That is, no damage occurs in the wafer 1 upon transportation the wafer 1.

This invention may be embodied as the following aspects.
(1) In the foregoing exemplary apparatus, the wafer 1 having an approximately circular shape is a target for treatment. This shape is not limitative. For instance, the wafer 1 may be a molded substrate having a quadranglar shape, such as a rectangular shape and a square shape. It is difficult to control transportation of the quadranglar substrate in a non-contact manner in comparison with the circular-shaped substrate. Consequently, the wafer may be damaged readily when the wafer contacts the wide wall for drop prevention. On the other hand, in the exemplary apparatus, the table and the suction head 30 are changed in size and shape so as to accommodate the substrate. This allows overcoming the problem mentioned above. Alternatively, the first table 21, the second table 22, and the suction head 30 of the wafer transporting mechanism 23 are formed into a quadranglar shape. Such configuration may be adopted.
(2) In the exemplary apparatus mentioned above, the temperature sensor 47 determines the temperature of the wafer 1 suction-held with the suction head 30. Then, when the temperature of the wafer 1 reaches a given temperature, the wafer 1 is delivered to the second table 22. Such configuration may be adopted.
(3) In the exemplary apparatus mentioned above, instead of using the heater 46 embedded in the suction head 30, the temperatures of the gas may be adjusted within the channel. For instance, a jacket for temperature adjustment may be attached on the channel 44. Here, warm water or cooling water is switchably supplied into the jacket 51 through two tanks.
(4) In the exemplary apparatus mentioned above, the reference value in STEP S4 for measuring warp of the wafer 1 may be set to have a given dead band, for example, taking in consideration of differences in thickness of the wafer 1.

It will be apparent to those skilled in the art that various modifications and variations can be made in the present invention without departing from the spirit or scope of the invention. Thus, it is intended that the present invention cover the modifications and variations of this invention provided they come within the scope of the appended claims and their equivalents.

## Claims

1. A method of transporting a substrate, comprising:
a transporting step of suction-holding a substrate in a heated condition with a box-shaped suction head in an unloading position and transporting the substrate into a loading position,
the substrate being formed by molding two or more chips arranged planarly with a resin,
during the transporting step, an outer periphery of the substrate being suction-held with the suction head, the outer periphery extending out of an exposed surface of the substrate on a surface side where the chips are exposed from the resin, and
the substrate being transported to the loading position while being kept planar by decreasing or increasing pressure within the suction head with switching between supplying heated air into the suction head sealed with the substrate and sucking the heated air from the suction head.

2. The method of transporting the substrate according to claim 1, wherein
pressure is applied within the suction head by supplying gas having temperatures between a preset temperature in the unloading position and that in the loading position, and
the substrate is delivered to a transport position when the resin is cooled down into a given temperature.

3. The method of transporting the substrate according to claim 2, wherein
a detector detects displacement in level of the substrate during the transport step, and at least either a supplied amount of gas into the suction head or a suction amount of gas from the suction head is adjusted in accordance with detection results from the detector.

4. The method of transporting the substrate according to claim 2, wherein
a temperature within the suction head is detected during the transporting step of the substrate, and a temperature of gas to be supplied into the suction head is adjusted in accordance with detection results from the detector

5. An apparatus for transporting a substrate, comprising:
a transport mechanism with a box-shaped suction head for suction-holding an outer periphery of the substrate formed by molding two or more chips arranged planarly with a resin in a heated condition, the outer periphery extending out of an exposed surface where the chips are exposed from the resin;
a gas compressor for supplying gas into the suction head sealed with the substrate or sucking the gas from the suction head;
a heater for heating the gas supplied from the gas compressor;
a detector for detecting displacement in level of the substrate suction-held by the suction head; and
a controller for adjusting at least either a supplied amount or a suction amount of the gas by detecting the displacement in level of the substrate during transporting while suction-holding the substrate with the suction head, and switching positive pressure and negative pressure within the suction head by the gas compressor in accordance with detection results from the detector.

6. The apparatus for transporting the substrate according to claim 5, further comprising:
a temperature sensor for detecting a temperature of the suction head sealed with the substrate, wherein
the controller compares an actual measurement value of the temperature determined by the temperature sensor with a reference value of the temperature determined in advance, operates the heater in accordance with deviation determined, and supplies the gas having a controlled temperature into the suction head.
